Europäisches Patentamt

European Patent Office

Office européen des brevets

(11) Publication number: **0 285 245**
**A1**

## EUROPEAN PATENT APPLICATION

(21) Application number: 88301340.1

(22) Date of filing: **18.02.88**

(51) Int. Cl.⁴ **H01L 21/312** , H01L 21/90

(30) Priority: **27.02.87 US 20332**

(43) Date of publication of application:
**05.10.88 Bulletin 88/40**

(84) Designated Contracting States:
**DE FR GB NL**

(71) Applicant: **AMERICAN TELEPHONE AND**
**TELEGRAPH COMPANY**
**550 Madison Avenue**
**New York, NY 10022(US)**

(72) Inventor: **Chandross, Edwin Arthur**
**14 Hunterdon Boulevard**
**Murray Hill New Jersey 07974(US)**
Inventor: **Hartless, Ray Lawson**
**62 Joanna Way**
**Phillipsburg New Jersey 08865(US)**
Inventor: **Yiu-Cho Lai, Warren**
**P.O. Box 868**
**New Providence New Jersey 07974(US)**
Inventor: **Larson, Ronald Gary**
**24C Troy Drive**
**Springfield New Jersey 07081(US)**
Inventor: **Reutlinger, George William**
**24 Kenneth Court**
**Florham Park New Jersey 07932(US)**
Inventor: **Schutz, Ronald Joseph**
**14 Upper Warren Way**
**Warren New Jersey 07060(US)**
Inventor: **Stillwagon, Larry Edward**
**73 Beechwood Road**
**Summit New Jersey 07901(US)**
Inventor: **Taylor, Gary Newton**
**236 Windmill Court**
**Bridgewater New Jersey 08807(US)**

(74) Representative: **Buckley, Christopher Simon**
**Thirsk et al**
**AT&T (UK) LTD. AT&T Intellectual Property**
**Division 5 Mornington Road**
**Woodford Green, Essex IG8 OTU(GB)**

(54) **Device fabrication involving planarization.**

㊲ Planarization of geometrically difficult device surfaces is accomplished utilizing a coating technique relying on relatively low viscosity materials. In particular, device processing is accomplished by including a step that produces a planar surface by coating a nonplanar surface with a material that has a viscosity of less than 1000 cp and which upon curing into a solid material undergoes a volume change of less than twenty percent.

## FIG. 4

## DEVICE FABRICATION INVOLVING PLANARIZATION

Background of the Invention

1. Technical Field

This invention relates to device processing and in particular device processing utilizing the planarization of a nonplanar surface.

2. Art Background

The fabrication of devices as semiconductor devices almost invariably produces surfaces which are nonplanar in configuration. For example, typically in the fabrication of silicon devices, a multiplicity of layers are formed sequentially on a silicon substrate. Many of these layers are processed into a desired pattern by selective deposition or by removing desired regions of the layer. As more and more layers are built upon underlying nonplanar layers, the irregularity of the surface becomes more and more pronounced.

Such irregularity in some situations presents significant problems. For example, the patterning of a layer is generally accomplished by a lithographic process; e.g., a photosensitive material is deposited, exposed to radiation in the desired pattern, and developed to reveal the exposed pattern. If the resist material is deposited to a reasonable thickness on an irregular surface, it too will have a corresponding irregularity. However, to produce a well-resolved exposure, it is necessary to focus the exposing light at a specific depth. If the resist material is not planar, the exposure image will not be entirely in focus across the water. Thus, the probability of obtaining degraded lithographic results is significantly increased.

To avoid this consequence, multilayer resist processes are employed. In multilayer resists, the purpose of the layer closes to the device layer being processed is to produce a more planar surface. A subsequent photosensitive resist layer is then formed, and this photosensitive planar layer is exposed and developed. The resulting pattern, which does not suffer from the previously described difficulties, is utilized as a mask to transfer the pattern through the planarizing layer, perhaps via intermediate layers, and ultimately to the device layer being processed. Despite this success it is, nevertheless, desirable to limit the height of the planarizing layer to avoid excessive processing times and undesirable loss of uniformity.

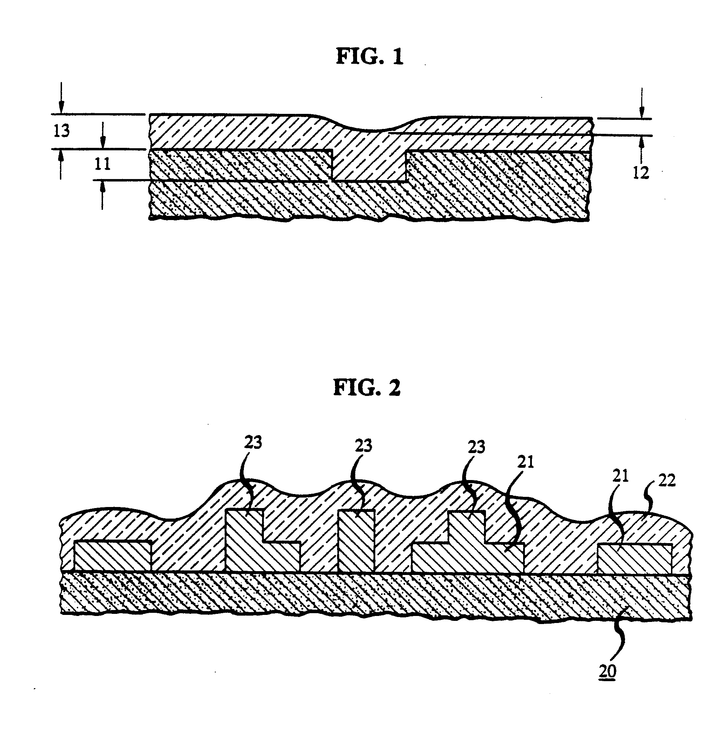

Other significant device fabrication procedures also require a planar surface. For example, to planarize a device surface by an etch-back technique, a material is deposited on it in a manner adapted to form a planar surface. If the device layer and the overlying material layer have approximately the same etch rate, etching proceeds through the planarizing material, with the surface configuration of the planarizing layer being transferred to the device material surface. Although this technique has been adequate for some applications where a modest degree of planarity is required, present overlaying materials are inadequate to furnish the necessary planar surface for demanding applications such as the precise removal of material on protruding features. (The degree of planarization is defined as the difference between the depth of a substrate feature $h_u$ as denoted by 11 in FIG. 1, and the depth of the overlying material surface $h_c$, as denoted by 12, this difference divided by the initial depth $h_u$ for a coating of thickness 13, i.e.,

$$(1 - \frac{h_c}{h_u}).)$$

Generally, for typical device configurations, planarization better than approximately 55 percent as calculated by the method described above has not been achieved for features greater than 75 $\mu$m in width. Thus for elongated gap type features greater than 100 $\mu$m in width and 0.5 $\mu$m in depth, the usefulness of an etch-back technique has been limited.

This limitiation is exemplified by procedures proposed for producing silicon devices having a multilayer metallized pattern. In these devices, the silicon device layer is contacted by a first metal pattern which is in turn connected by metallized vias through an interposed dielectric layer to a second overlying metallized pattern. A variety of techniques have been contemplated for fabricating these devices. The nonplanarity introduced by the via connections generally severely limits these techniques. One such technique which

2

**0 285 245**

exemplifies these difficulties is described by R.E. Oakley, et al, in <u>VLSI Multilevel Interconnection Conference,</u> New Orleans, Louisiana, June 21-22, 1984, and M. T. Welch, et al, <u>VLSI Multilevel Interconnection Conference,</u>, Santa Clara, California, June 9-10, 1986. In this technique, a first metallized pattern 21 in FIG. 2 having metal columns, 23, (referred to at times as pillars, studs, or bumps) corresponding to the desired vias is produced. The metallized pattern 21 in FIG. 2 with its pillars 23 is then covered with a layer of silicon dioxide 22 having a nonplanar configuration corresponding to the nonplanarities introduced by the pillars, 23, the metal pattern, 21, and other underlying topography. The regions of silicone dioxide covering the pillars must then be removed to allow contact with the second metal pattern. Because of the nonplanarity of the silicone dioxide, it is extremely difficult to control the procedure utilized to effect this goal. Although processes including etchback planarization and two sequential, aligned levels of lithography have been attempted, the results have not been entirely satisfactory. (See Welch, et al, <u>supra</u>.) The additional steps introduce unacceptable costs, decreased yields are obtained, and/or processing control difficulties arise. Thus, the problems introduced by nonplanar configurations and the limited success in dealing with these configurations are anticipated to worsen with the evolving sophistication of very large scale integration.

Summary of the Invention

It has been found that processes involving planarization are substantially enhanced through the use of a planarization step relying on a material of appropriate viscosity. In particular, a planarization step in a device fabrication procedure is desirably performed employing a planarization material which before solidifying in the layer formation procedure has a viscosity less than 1000 centipoise and greater than 30 centipoise, and which upon solidification, e.g., curing is reduced in volume by less than 20 percent. Although the exact mechanism involved in achieving enhanced planarization utilizing such materials is not fully resolved, it is contemplated that the material after coating undergoes substantial flow and is able to accommodate the movement of the large volume of material required for planarization of an irregular surface.

The use of the inventive process affords results that were previously unobtainable. For example, in the case of producing a multilayer metallization configuration, it is possible through the use of a material such as trimethylolpropane trimethacrylate (TMPTMA) to obtain, after curing, is an etch-back procedure, a multilayer patter having resolved pillar vias. The improvement in planarization compared to that previously achieved is demonstrated by the planarization of a structure such as that shown in FIG. 1. With a material such as TMPTMA average planarizations on the order of 85% have been achieved for a TMPTMA thickness of 2.1 $\mu$m over 250 $\mu$m wide gap. In contrast, a planarization of only approximately 25 percent is achievable for a comparable thickness with a material such as polyester resin that initially has a high viscosity and that, upon heating, undergoes rapid viscosity changes. Thus, the use of materials that have relatively higher viscosity, and undergo rapid viscosity changes upon heating to preclude adequate flow or the use of materials such as positive photoresists which solidify during spinning and do not undergo substantial flow upon heating after spinning, leads to significantly degraded results compared to the inventive process.

Not only is improved planarization achievable for a given surface configuration, but conversely, for a desired degree of planarization it is possible to acceptably process substantially more severe topography.

Brief Description of the Drawing

FIGS. 1 to 3 are illustrative of configurations involved in the invention.
FIG. 4 is illustrative of a procedure for determining planarization of materials.
FIG. 5 is illustrative of an embodiment of the invention.
FIGS. 6 and 7 are illustrative of conditions involved in practicing the invention.

Detailed Description

As discussed, the inventive device fabrication procedure including a specific planarization process yields great flexibility for device fabrication. As noted, when a specific feature is dictated by design considerations, the degree of planarization of this feature is substantially enhanced through use of the inventive procedure. Similarly, when a desired degree of planarization is essential in a device fabrication procedure and where there is flexibility in the particular structure, substantially more irregular features are suitably planarized utilizing the inventive technique. Since this interdependency between degree of planarization and surface geometry is a significant aspect of the invention, as a pedagogic aid a description of surface geometry is addressed first and then relationship between this geometry and attainable planarization is discussed.

## Geometry

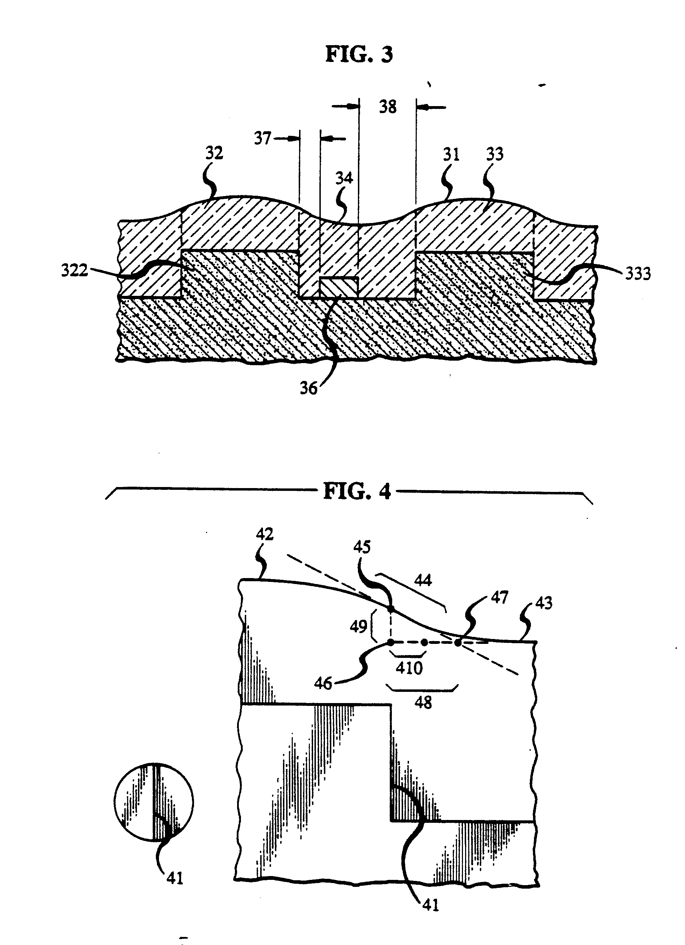

For almost any device geometry certain features will be significantly more difficult to planarize with an overlying layer than the rest. These features (denoted as critical features for the purpose of this description) are characterized by their relative position to the broad features of the device and their effect on device operation. Most significantly, the height of the feature (the dimension measured in a direction perpendicular to the substrate surface) does not significantly affect the difficulty in planarizing a particular feature. A feature is critical when 1) the device performance is degraded because of failure to achieve the desired planarization, and 2) it is at least 75 microns from a major feature. For purposes of determining the presence of a major feature, such a feature is defined as one whose largest dimension is at least 75 microns. (If a space between features is less than 30 microns measured perpendicular to a feature edge and propagating across the feature, the features and the intervening space(s) are considered as one in determining whether the entire structure is a major feature.) Thus, a critical feature in a collective sense is one that is spaced significantly from a second feature where the material overlying this second feature after coating defines a large volume of potentially planarizing material. For example, as shown in FIG. 3, the planarizing material 31, as initially coated onto the substrate, produces planarization by flowing from the reservoirs of material 32 and 33 over the major features 322 and 333 into the volume 34 above the critical feature 36 to produce the configuration shown.

Generally, if the most difficult critical feature to planarize is in fact planarized, the remaining critical features are also planarized. Thus, for purposes of determining whether a feature is planarized or not, it is sufficient to determine whether the most difficult feature on a device is planarized. The most difficult, critical feature is most easily found through the use of a control sample. For example, a representative planarizing material is coated on the substrate and the degree of planarizing for each critical feature is noted. From these measured data it is easy to determine which is the most difficult critical feature to planarize.

## Degree of Planarity

It is also possible to determine to a good approximation whether a particular planarizing material will planarize the most difficult critical feature. In particular, a sample wafer is prepared having a step such as that shown in 41, in FIG 4, running across the wafer at its midpoint and represented in cross-sectional and plan views. Generally, for ease of measurement this step should be at least 0.50 $\mu$m in height, although this dimension is not particularly critical. The material to be tested is then applied to the wafer in the manner which is contemplated for coating of the device. Generally, this procedure will yield a representative coating such as shown in FIG. 4. In such a profile, there are generally two surfaces, 42 and 43, that are substantially parallel to the substrate surface and a third surface 44 which forms a transition between these two substantially parallel surfaces. The midpoint in this transitions surface 45 is taken as a point of reference.

Considering this reference point 45 in FIG. 4, construction of a verticle line downwards from it to point 46 intersecting with the extension of parallel surface 43 creates segment 49. This line segment is considered to represent 100% planarization for a given feature defined as the critical feature in FIG. 3. Construction of a least-squares-fitted-line through the linear portion of the transition region 44 creates another intersection point 47 on the extension of surface 43. The line segment 48 denotes the feature width undergoing the smallest volume change contiguous to the critical feature, item 37 in FIG. 3. Dimension 48 represents the maximum dimension for which a material achieves some degree of planarization. For a particular device configuration, for which FIG. 3 is exemplary, having a critical feature 36 located a minimum distance 37 from its closest major feature 322, the planarization is approximated by:

$$\text{Planarization (percent)} = 100 \frac{\left[ D_{49} - \frac{D_{49}}{D_{48}} (D_{410}) \right]}{D_{49}}$$

in which the dimension 37 in FIG. 3 is equal to the dimension 410 in FIG. 4. (In this equation, D specifies a dimension and its subscript pertains to the notations in FIG. 4.) $D_{49}$ $D_{48}$ is the slope of the linear portion of the transition region 44 and is characteristic of the planarizing ability of a given material independent of feature dimensions. Table 1 summarizes measurements of such slopes (termed planarization tendency) over a 1.1 $\mu$m step for a variety of materials tested in the course of realizing the inventive process.

T A B L E   1

| Material | Leveling Conditions | Thickness* ($\mu$m) | Planarization Tendency $D_{49}/D_{48}(\times 10^3)$ |
|---|---|---|---|
| Positive Photoresist, HPR-206 (Philip A. Hunt Corp.) | 220 °C for 15 min | 1.8 | 22.0 |
| Polyester Resin PC1-1500D (Futurrex Corp.) | 200 °C for 45 sec | 2.1 | 10.6 |
| Trimethylolpropane Trimethacrylate (TMPTMA) | 23 °C for 10 min | 1.6 | 1.2 |
| TMPTMA | 23 °C for 10 min | 4.7 | 0.8 |
| 3,4-Epoxycyclohexylmethyl 3,4-Epoxycyclohexane-carboxylate (Epoxy A) | 23 °C for 10 min | 2.0 | 2.7 |
| Epoxy A | 23 °C for 10 min | 5.5 | 2.0 |
| Digycidyl Ether of Cyclohexane dimethanol (Epoxy B) | 23 °C for 10 min | 1.7 | 1.3 |
| Epoxy B | 23 °C for 10 min | 4.4 | 0.9 |

*Thickness after solidification.

It has been found that the estimate so obtained is extremely good for small critical features. i.e., critical features having a width less than 100 microns. For relatively large critical features, i.e., features having a width greater than 200 microns, generally the error is between 10 and 20 percent of the estimated value. However, in circumstances where the critical feature is very close to a major feature, such as shown in FIG. 3, the error tends to be somewhat larger.

In the previous discussion, it was noted that the distance represented by 410 in FIG. 4 relates to the distance between the critical feature and its closest major feature 37 in Fig. 3. In particular, this is the distance between the feature providing the greatest reservoir of planarizing material and the closest surface of the most difficult critical feature. For example, as shown in FIG. 3 both regions 32 and 33 provide reservoirs of planarizing material. The reservoir provided by 33 is the same as that for reservoir 32. However, if 33 is larger than 32, the critical dimension is still the distance 37 since region 32 constitutes a major feature and provides sufficient material, to a good approximation, more rapidly than material from 33 due to its closer proximity to critical feature 36.

Thus, through the use of control wafer having a single step in its center, it is possible to relate the potential planarization obtainable for a given material applied to a specific device geometry. It is also possible by the same procedure to design a particular device geometry and through the use of the control sample determine whether it is likely to be planarized to a desired degree.

To obtain the desired results in a process having a planarization step, the surface to be planarized is treated with a freely flowing material, i.e., a material that has a viscosity less than 1000cp, preferably less than 200cp, and most preferably less than 100cp. This material should be capable of being solidified. (Solidification occurs when the material reaches a state that has a glass transition temperature greater than or equal to 40 °C.) For example, a monomer mixture containing suitable photosensitizer(s) is utilized which, upon irradiation with a suitable form of energy, undergoes a chemical reaction and solidifies. Monomer materials such as 1) acrylic and methacrylic esters, and 2) aromatic and aliphatic epoxies are exemplary of suitable monomers while 1,1-dimethoxyacetophenone is exemplary of suitable photosensitizers. Upon solidification, the planarizing material should undergo a volume change of less than 20%. Thus, materials dissolved in a suitable solvent generally are not desirable since upon solvent evaporation and the resulting solidification they yield a highly viscous or solid film and do not flow. This solidification during coating makes planarization more difficult than the enhanced planarization achievable by the invention. The material should remain in the desired viscosity range for a time sufficient to allow flow. Additionally, the material should be in this viscosity range before solidification is induced such as by heating or irradiation. Some materials upon heating initially become less viscous, but the heating also induces a chemical reaction resulting in solidification. Thus, the lowered viscosity is transitory and such materials are typically inadequate.

The thickness of the planarization layer after solidification should be from one and one-half to 10 times $h_u$. Thicknesses greater than 10 $h_u$ are not desirable because of typically undesirable uniformities and excessive processing time, while thicknesses less than 1.5 $h_u$ are also not desirable because of inadequate planarization by material above the highest topographic regions. The method of achieving this thickness is not critical. Procedures such as spin coating, curtain coating, or spray coating are useful provided the desired thickness is achieved. It is also desirable that thickness non-uniformity, i.e., thickness variations over an entire device or wafer, be maintained in the range 0.05 $\mu$m to 0.2 $\mu$m. If a thickness non-uniformity greater than 0.2 $\mu$m is produced, undesirable results are obtained. The boiling point should also be at least 200° C such that materials do not excessively evaporate prior to hardening. It is also typically desirable that the material be sufficiently viscous, typically having a viscosity greater than 30 centipoise so that it retains its cohesiveness. The material should be chosen to wet the surface being coated so that dewetting does not occur. It is desirable that the thickness for the planarizing material be achieved over at least 80 percent of the substrate being coated, and that between 30 and 3600 seconds be allowed to pass between coating and solidification. Shorter times generally do not yield adequate planarization, although longer times are not precluded.

In addition to appropriate viscosity and solidification properties, the materials utilized for planarizing should also have the properties necessary for the ultimate use in the device fabrication sequence. For example, if the planarizing material is to be utilized in an etch-back scheme, then the material should undergo removal by a specific etchant at a rate similar to the underlying material. If the material is to be utilized as a layer in a multilayer resist, the material should be susceptible to pattern transfer from the overlying photosensitive material. Exemplary materials suitable for etch-back procedures with underlying composition such as silicon dioxide are aromatic acrylic and epoxy monomers, while these materials are also suitable for utilization in multilayer resists. Additionally, it is desirable that the solidified planarization material have a $T_g$ higher than temperatures that are to be employed in subsequent processing steps. If the

$T_g$ is lower, an undesirable change in surface configuration will generally occur upon subjecting the solidified planarization layer to those temperatures.

Specific Embodiments

The inventive fabrication technique is advantageously employed to make devices having a multilayer metallic patterns with interconnecting metallic pillars. In this technique, a first metallized pattern with pillars on the pattern in the desired position is produced. The method of producing this structure is not critical. However, it has been found that a particularly advantageous technique involves the use of alternating layers having different etching properties. Alternating layers of aluminum and tungsten are advantageously employed. During processing, the etching of aluminum with a chlorine based plasma, e.g., $Cl_2 \, BCl_3$, is utilized so that tungsten is not significantly etched. Fluorine based plasmas, e.g., $CF_4 \, O_2$ or $CF_3 Cl$, are employed to etch the tungsten layer so that aluminum is not significantly etched.

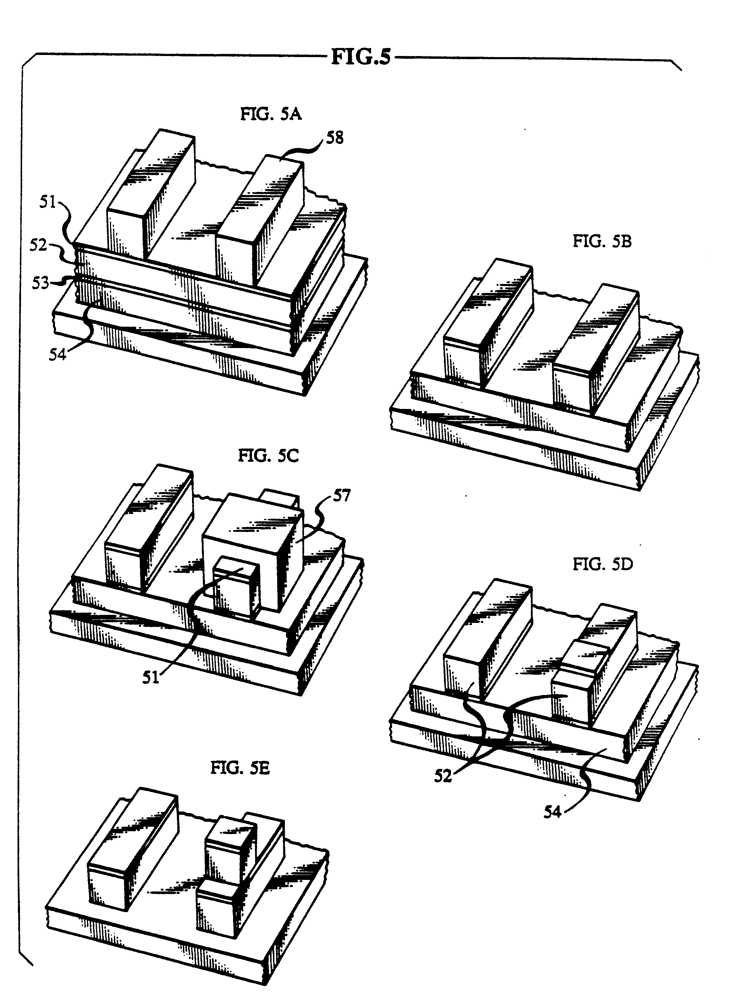

In one embodiment illustrated in FIG. 5, a layer of aluminum 54, a layer of tungsten 53, a second layer of aluminum, 52, and a second layer of tungsten, 51, are deposited on the device structure. A resist material, 58, is patterned on the uppermost tungsten layer so that the pattern corresponds to the pattern desired in the lowermost aluminum layer. The remaining uncovered tungsten 51, the underlying aluminum 52, and the tungsten underlying this aluminum layer 53 are removed by sequential etching processes. Since the tungsten removal process leaves the underlying aluminum unaffected, the etching procedure is terminated before the lowermost aluminum layer is adversely affected and results in the structure shown in 5B. After etching, the resist layer, 58, is removed, and a second resist material, 57, is applied and delineated so that regions where pillars are to occur are covered with the resist. This sequence is advantageous since the alignment of this resist pattern is not critical because resist that is over the lower aluminum does not result in any unwanted pattern. The exposed regions of tungsten, 51, in FIG. 5C are removed, and the remaining resist, 57, is stripped. This leaves exposed areas of aluminum in both the first 52 and second 54 aluminum layer as shown in 5D. All exposed aluminum regions are then removed simultaneously leaving the desired pattern of aluminum together with a pillar composite of tungsten and aluminum as shown in 5E.

The pillar structure is coated with a conformal dielectric layer, e.g., a $SiO_2$ layer, at a temperature low enough to leave the aluminum essentially unaffected and is then planarized utilizing a material, such as TMPTMA, which is etched in a $CF_4 \, O_2$ plasma at approximately the same rates as the dielectric layer and which has the appropriately viscosity and solidification properties. This etch is continued until a portion of each pillar is exposed. (The use of the desired planarization process produces this desirable result while inadequate planarization results in the removal of dielectric over aluminum lower layer critical features.) The second metallized pattern is then formed by metal deposition preceded by in-situ sputter cleaning to ensure contact integrity.

The inventive fabrication procedure is not limited to the production of multilayer metallic patterns with interconnecting conductive vias. A multitude of devices are advantageously fabricated. Indeed, any fabrication sequence relying on a planarization step that requires planarization with volume changes, and spacing parameters within the previously discussed ranges is advantageously undertaken by the inventive process.

The following examples are exemplary of suitable conditions employed in the inventive procedures.

EXAMPLE 1

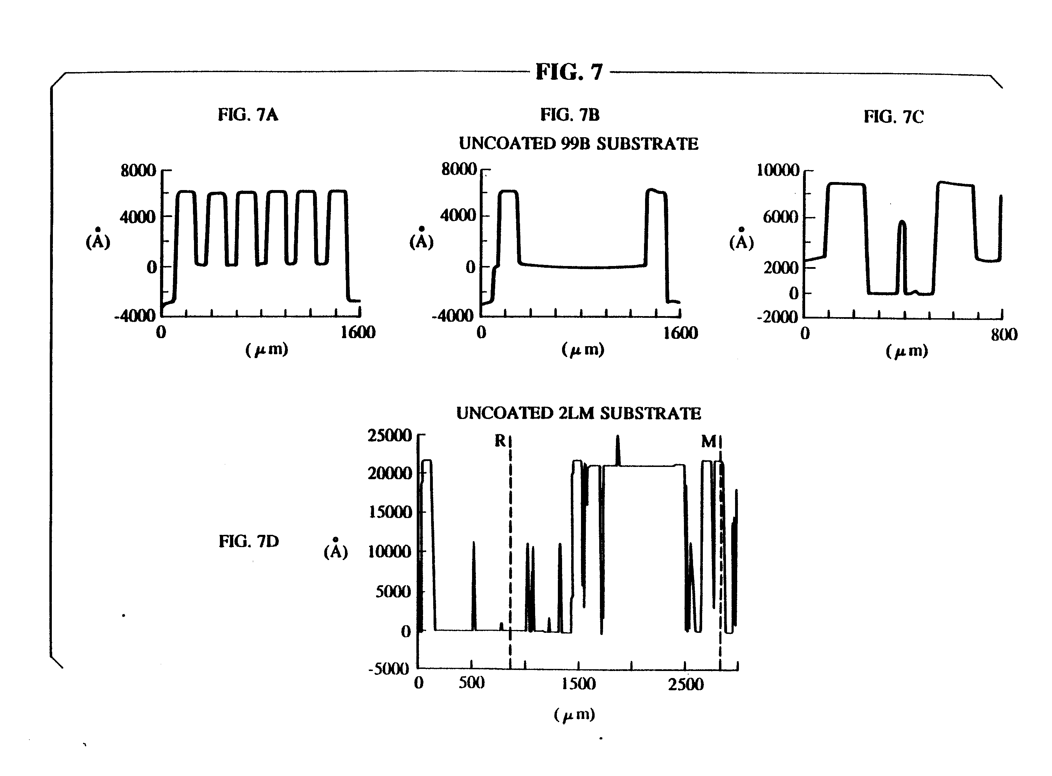

A substrate that simulates the topography of the polysilicon level of a 4 kbit random access memory device (99B substrate) was used to evaluate the planarizing capabilities of various coatings described in Examples 1-3, 7 and 8. FIG. 7 at 7A, 7B, and 7C shows profilometer traces of three different types of topographic features on the uncoated substrate:
(a) a series of 150 μm wide pads separated by 75 μm wide gaps that are about 0.6 μm deep, (b) two 150 μm wide pads separated by a 1000 μm wide gap that is 0.6 μm deep, and (c) two 150 μm wide pads separated by a 250 μm wide, 0.9 μm wide deep gap that has a 20 μm wide, 0.6 μm high post running through the center of the gap. The planarizing capability of various coatings was evaluated by measuring the profile of these three features before and after coating. Values for the planarization were calculated using the equation:

$$\text{Planarization (percent)} = 100 \, \frac{(h_u - h_c)}{h_u}$$

where $h_u$ and $h_c$ are the depth of the uncoated and coated substrate features, respectively. A film of trimethylolpropane trimethacrylate (TMPTMA) containing 5 % by weight of the photoinitiator, Irgacure 651, 1,1-dimethoxyacetophenone from Ciba Geigy Corp., was spin coated onto a topographic substrate at 3000 rpm for 50 seconds to yield a 3 $\mu$m thick liquid film. The substrate was allowed to set horizontally and undisturbed for a 10 minute period during which time the topographic gaps were leveled. The film was then solidified (cured) under a nitrogen atmosphere by a 5 minute exposure to UV light emitted by an Optical Associates exposure tool having a 500w high pressure mercury arc lamp. The incident dose was 2.75J/cm² as measured at 310 nm and 0.75J / cm² at 260 nm. The planarization values for the 75,250 and 1000 $\mu$m wide gaps were 86, 88 and 78%, respectively.

## EXAMPLE 2

A film of 3,4-epoxycyclohexylmethyl 3,4-epoxycyclohexanecarboxylate (Epoxy A) containing 4 wt % of the photoinitiator UVE - 1014, a 50-50 percent mixture of a triarylsulfonium hexafluoroantimonate and propylenecarbonate from General Electric Corp., was spin coated at 4000 rpm for 300 seconds onto a 99B topographic substrate. The 2.1 $\mu$m thick film was cured after a 10 minute leveling period by a 30 second exposure to UV light from a 1 kw high pressure mercury arc lamp in an Oriel exposure tool. The incident dose was 3.3 J/cm² measured at 310 $\mu$m and 1.1 J/cm² at 260 nm. The planarization values for the 75, 250 and 1000 $\mu$m wide gaps were 95, 72 and 70%, respectively.

## EXAMPLE 3

The diglycidyl ether of cyclohexane-1,4-dimethanol (Epoxy B) containing 18 wt % UVE-1014 was spin coated onto a 99B topographic substrate at 8000 rpm for 80 seconds to yield a 2 $\mu$m thick film. The film was cured as described in Example 2 after a 10 minute leveling period. The planarization values for the 75, 250 and 1000 $\mu$m wide gaps were 89, 78 and 81%, respectively.

## EXAMPLE 4

A two-level metal interconnection tester (2LM substrate) was used to further evaluate the coatings in Examples 4-6. FIG. 7 shows a profilometer trace of the topography (7D) used in these planarization evaluations. The feature consisted of two 100 $\mu$m wide, 2 $\mu$m high bonding pads separated by a 1300 $\mu$m wide gap that is about 2 $\mu$m deep. Four metal runners about 25 $\mu$m wide and 1 $\mu$m high were inside the gap perpendicular to its longest dimension. An 800 $\mu$m wide dense field of 2 $\mu$m high pillars sat to the right of the gap while the regions to the left of the gap were sparsely occupied.

A mixture by weight of TMPTMA and 5% of Irgacure 651 sensitizer, described in Example 1, was spin coated onto a 2LM substrate at 3000 rpm for 20 seconds yielding a 5 $\mu$m thick film. The film was cured as previously described after standing for a 10 minute leveling period. The coated substrate was appropriately sectioned and examined using a scanning electron microscope (SEM). Film thicknesses were measured from SEM photographs taken at various positions across the features shown at 7D. The planarization of the 1300 $\mu$m wide gap by the TMPTMA film was about 50% as measured above the 25 $\mu$m wide metal runner nearest the 150 $\mu$m wide pads on the left-hand side of the feature. (The two-level metal interconection process requires that the TMPTMA film be thicker above the 1 $\mu$m high pillars located in the 1300 $\mu$m wide gap than above the 2 $\mu$m high bonding pads, preferably by a thickness difference of at least 0.5 $\mu$m. A 50 % planarization value means the thickness difference between the two features is zero).

Improved planarization was achieved by using a thicker TMPTMA film. A film spin coated at 2000 rpm for 20 seconds onto a 2LM substrate was about 7 $\mu$m thick. The film was cured after a 10 minute leveling period and examined by SEM as described above. The planarization of the 1300 $\mu$m wide gap was about 80% which was sufficient for the two-level metal interconnection process.

EXAMPLE 5

Mixtures of TMPTMA and ethoxylated bisphenol A dimethacrylate (SR348 from ARCO Speciality Chemicals Co.) were evaluated as planarizing materials. Compositions containing 5 wt % of Irgacure 651 were spin coated onto 2LM substrates and cured as described in Example 1 after a 10 minute leveling period. The uncured films were about 6 μm thick prior to leveling. The planarization of the 1300 μm wide gap was estimated from profilometer traces to be 70% and 55% for films containing a 3:1 and 1:3 mixture, by weight, of TMPTMA and SR348, respectively.

EXAMPLE 6

Mixtures of benzyl methacrylate and SR348 were evaluated as planarizing materials. Compositions containing 4 wt % Irgacure 651 were spin coated onto 2LM substrates and cured as described in Example 1. After a 10 minute leveling period, the uncured films were about 8 μm thick prior to leveling. The planarization of the 1300 wide μm gap was estimated to be about 65% for both the 4:1 and 1:1 compositions by weight of benzyl methacrylate and SR348.

EXAMPLE 7

The effect of viscosity on leveling time required to achieve a certain degree of planarization was investigated using the epoxy resins in Examples 2 and 3. The mixture by weight of epoxy A and 4% UVE1014 had a viscosity of about 320 centistrokes (cs), while the epoxy B,18% UVE1014 mixture had a viscosity of about 75 cs. Films about 2 μm thick were prepared by spin coating onto 99B topographic substrates (see Example 1) and were cured by a 30 second exposure to light from the Oriel exposure tool used in Examples 2 and 3. Only a few seconds exposure time (less than 5 seconds) was actually required to harden the film and stop flow. The planarization of the 1000 μm wide gap was measured from profilometer traces. FIG. 6 shows a plot of planarization (percent) of the 1000 μm wide gap versus leveling time for the two epoxies. The initial slope of the curve for epoxy B($\eta = 75$ cs) was 3-4 times lower than that for the epoxy A ($\eta = 320$ cs) curve. Thus, the leveling time required to achieve a certain degree of planarization appeared to be directly proportional to the film viscosity.

EXAMPLE 8

The effect of film thickness on leveling time was investigated using the mixture of epoxy A and 4 wt % UVE1014 (see Example 2). Films having a 2.1 μm thickness were formed by spin coating onto 99B topographic substrates and cured after 15, 30 and 120 second leveling times. The planarization of the 75, 250 and 1000 μm wide gaps was measured from profilometer traces. The planarization achieved by epoxy A films coated onto 99B substrates at initial thicknesses of 3.3 and 4.3 μm and cured after 30 and 15 second leveling times, respectively, was also measured. Table 2 lists the planarization values for the five films. The 4.3 μm and 3.3 μm thick films cured after 15 and 30 second leveling periods, respectively, achieved higher degrees of planarization than the 2.1 μm film cured after 15 or 30 second leveling periods.

## T A B L E 2

### DEPENDENCE OF FILLING TIME ON FILM THICKNESS FOR EPOXY A FILMS SPIN COATED AT 4000 RPM

| Spinning Time (sec) | T* ($\mu$m) | Leveling Time (sec) | Planarization (%) | | |
|---|---|---|---|---|---|
| | | | 75 $\mu$m | 250 $\mu$m | 1000 $\mu$m |
| 300 | 2.1 | 15 | 53 | 19 | 11 |
| 300 | 2.1 | 30 | 73 | 26 | 22 |
| 300 | 2.1 | 120 | 88 | 50 | 50 |
| 110 | 3.3 | 30 | 92 | 51 | 56 |
| 70 | 4.3 | 15 | 93 | 51 | 60 |

*Thickness after spin coating

The degree of planarization achieved by the thicker films was almost identical to that obtained with 2.1 $\mu$m thick film cured after a longer 120 second leveling period. The 4.3 and 3.3 $\mu$m thick films were about 2.1 and 1.6 times thicker and appeared to level the gaps 9 and 4 times faster, respectively, than the 2.1 $\mu$m thick film. Thus, the leveling time appeared to be inversely proportional to the cube of the film thickness.

### EXAMPLE 9

Organic materials containing aliphatic carbon atoms and oxygen atoms are usually less resistant than polymers containing only carbon atoms to plasma etching conditions used for pattern transfer to underlying substrate layers. Materials containing aromatic carbon atoms and low or zero percentages of oxygen atoms are more etch resistant with low erosion rates being achieved by high $T_g$, high aromatic content organic glasses. To produce these properties in planarization layers, planarizaion was studied with aromatic epoxies analogous to the aliphatic materials of Examples 2 and 3. In this instance, the 99B topographic substrates were spin coated with mixtures of resorcinol diglycidyl ether (RDGE, $\eta = 265$ cp) and p-t-butylphenyl glycidyl ether (BPGE, $\eta = 22$ cp) and 8 wt % UVE-1014. The addition of low viscosity aromatic reactive diluents was utilized to minimize the viscosity and thus maximize flow without adversely affecting the cure, shrinkage or etch resistance. Two types of cure were employed, a 40 sec irradiation as in Example 2 or a 3 sec irradiation followed by heating for 5 min at 155°C. Planarization results for various compositions at a thickness of 2.0 $\mu$m are summarized in Table 3.

## TABLE 3

### PROPERTIES OF RDGE - BPGE PLANARIZING FILMS

| Wt % RDGE | Wt % BPGE | $\eta$ (cp) | Spin Speed (k rpm) and Time (secs) | Leveling Time (min) | Thickness (μm) | Cure Type | % Shrinkage Upon Curing | Planarization (%) | | |
|---|---|---|---|---|---|---|---|---|---|---|
| | | | | | | | | 75 μm Gap | 250 μm Gap | 1000 μm Gap |
| 100 | 0 | 265 | | | | | | | | |
| 75 | 25 | 82 | 6.0,118 | 10.0 | 2.1 | L | 7 | 83 | 76 | 74 |
| 50 | 50 | 46 | 4.0,117 | 6.0 | 2.0 | L,II | 8 | 85 | 78 | 77 |
| 25 | 75 | 26 | 4.0,51 | 6.0 | 1.9 | L | 17 | 66 | 53 | 51 |
| 0 | 100 | 22 | | | 2.0 | L | 47 | | * | |

*De-wets From Substrate, Excessive Shrinkage

Best results were obtained for the 4:1 RDGE, BPGE mixture which had excellent adhesion and planarization properties and little shrinkage. In addition, its selectivity relative to positive photoresist in a $BCl_3$, $Cl_2$ plasma used to etch aluminum was 1.6 whereas that for TMPTMA was 2.5.

## EXAMPLE 10

In a fashion analogous to Example 9, mixtures of aromatic acrylates or methacrylates with their aliphatic homologues were used to improve etch resistance without sacrificing planarization ability. A 1:1 mixture of ethoxylated bis-phenol-A dimethacrylate (SR-349 from ARCO Specialty Chemicals Co.), TMPTMA and sensitizers lrgacure-651 (0.5 wt %) and N-vinylcarbazole (0.5 wt %) was spin coated for 100 sec on a 99B topographic substrate to give a 2.1 μm thick coating. After sitting for 10 min, the film was cured by UV irradiation for 5 minutes under nitrogen as in Example 1. The resulting film achieved 75% planarization for 75 μm gaps and 67% for 250 μm gaps and had an etch selectivity to a $BCl_3$, $Cl_2$ plasma as in Example 9, of 1.8 versus 2.5 for a TMPTMA film.

## EXAMPLE 11

A solution comprised of 80 parts of poly(α-methylstyrene) Kristalex 3085 resin from Hercules, Inc. ( $\overline{M}_w$ = 900 g/mole and polydispersity = 3.1) and 100 parts chlorobenzene was used to form a 2.8 μm thick film on a 99B substrate by spin coating at 4000 rpm for 1 minute. The coated substrate was heated on a hot plate for 15 minutes at 95 °C to give a planarized structure in which the 75 μm pads had 82% planarization and the 250 and 1000 μm features exhibited 36 and 42% planarization, respectively. Film thickness loss upon heating was 11% of that for the coated but unheated sample.

The planarization properties of Kristalex resins were superior to those of analogous polystyrene Piccolastic resins from Hercules. Inc. when coated and heated in a similar manner. The Piccolastic resins contain two components, a low molecular weight oligomeric portion ( $\overline{M}_w$ = 950 g/mole, polydispersity = 2.6) and a higher molecular weight polymeric resin ( $\overline{M}_w$ = 7.4-8.8 × $10^4$ g/mole, polydispersity = 2.4). Viscosity is controlled by changing the ratio of the two components. Portions of the low molecular weight component are volatilized during heating needed to flow the resin, thus raising the viscosity and reducing flow. This occurred to a significantly reduced degree for the single component Kristalex resins. These resins also proved less prone to oxidative crosslinking upon heating which tended to raise viscosity and retarded the flow needed for planarization.

The lowest viscosity Piccolastic resin D100 was mixed by weight with an equal amount of chlorobenzene and the resulting solution was used to spin coat a 99B substrate at 4000 rpm for 1 minute to give a 2.4 μm thick film. Heating at 90°C for 15 minutes planarizaed the 75 μm pads only slightly (11%) while reducing the film thickness by 10%.

## Claims

1. A process for fabricating a device comprising the steps of
1) forming a material region on a substrate containing a critical feature and including solidification of said region to produce a surface more planar than the surface of said substrate, and
2) completing said device utilizing the properties of said material,
CHARACTERISED IN THAT said material region between said formation and said completion has a viscosity in the range 30 to 1000 cp, stays in said viscosity range for a sufficient time to allow flowing of said material, stays in said viscosity range before said induction of solidification, and undergoes a reduction in volume of less than 20% whereby the planarization obtained is adequate for said critical feature.

2. The process of claim 1, CHARACTERISED IN THAT said device comprises a semiconductor device.

3. The process of claim 2, CHARACTERISED IN THAT said critical feature comprises a transistor gate.

4. The process of claim 2, CHARACTERISED IN THAT said completion comprises an etching process.

5. The process of claim 2, CHARACTERISED IN THAT said completion comprises a lithographic process.

6. The process of claim 4, CHARACTERISED IN THAT said material comprises trimethylolpropane trimethacrylate.

7. The process of claim 1, CHARACTERISED IN THAT said material comprises trimethylolpropane trimethacrylate.

8. The process of claim 1, CHARACTERISED IN THAT said solidification is accomplished by subjecting said material to ultraviolet radiation.

9. The process of claim 8, CHARACTERISED IN THAT said viscosity range is reached by heating said material.

10. The process of claim 1, CHARACTERISED IN THAT said solidification is induced by sequential irradiation and heating.

11. The process of claim 1, CHARACTERISED IN THAT said material comprises poly(α-methylstyrene).

12. The process of claim 1, CHARACTERISED IN THAT said material comprises an aromatic epoxy resin.

13. A process for producing a device. CHARACTERISED BY the steps of 1) on a substrate forming a structure having alternating layers of a first and second material wherein each of said materials is capable of being etched without substantially affecting the other. 2) etching said first layer of said second material. said second layer of said first material and said second layer of said second material in a desired pattern wherein said first layer of said first material is nearest said substrate, 3) masking regions on said pattern where interconnects are desired, 4) etching said second layer of said second material with said etchant that leaves said first material substantially unaffected, 5) removing said mask and etching said first material with said etch which leaves said second material substantially unaffected to produce said interconnects, 6) depositing a layer of planarizing material, and 7) etching back said planarizing material to expose said interconnects.

14. The process of claim 13, CHARACTERISED IN THAT said first material comprises aluminum.

15. The process of claim 14, CHARACTERISED IN THAT said second material comprises tungsten.

16. The process of claim 15, CHARACTERISED IN THAT said device comprises a semiconductor device.

17. The process of claim 16, CHARACTERISED IN THAT said planarizing material comprises trimethlolpropane trimethacrylate.

18. The process of claim 16, CHARACTERISED IN THAT said etchant for said first material comprises a chlorine plasma.

19. The process of claim 16, CHARACTERISED IN THAT said etchant for said material comprises a fluorine plasma.

20. The process of claim 13, CHARACTERISED IN THAT said device comprises a semiconductor device.

**FIG. 1**

**FIG. 2**

## FIG. 3

## FIG. 4

# FIG.5

### FIG. 5A

58

51

52

53

54

### FIG. 5B

### FIG. 5C

57

51

### FIG. 5D

52

54

### FIG. 5E

# FIG. 7

### FIG. 7A

### FIG. 7B

### FIG. 7C

**UNCOATED 99B SUBSTRATE**

**UNCOATED 2LM SUBSTRATE**

### FIG. 7D

0 285 245

European Patent Office

**EUROPEAN SEARCH REPORT**

Application Number

EP 88 30 1340

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | US-A-4 619 837 (ADVANCED MICRO DEVICES INC.) * Page 2, line 48 - page 4, line 61 * | 1,2,8 | H 01 L 21/312 H 01 L 21/90 |
| A | | 7,10-13 ,17,20 | |
| A | EP-A-0 150 359 (IBM CORP.) * Figures 1,2; abstract; page 13, lines 15-22 * | 3 | |
| D,A | VLSI MULTILEVEL INTERCONNECTION CONFERENCE, New Orleans, Louisiana, 21st - 22nd June 1984, pages 23-29; R.E. OAKLEY et al.: "Pillars - the way to two micron pitch multilevel metallisation" * Figure 3E * | 4 | |
| A | FR-A-2 392 495 (R.T.C.) * Page 23, line 1 - page 24, line 28; figure 2 * | 1,5 | |
| A | EP-A-0 047 184 (E.I. DU PONT DE NEMOURS AND CO.) * Page 6, lines 14-38; page 2, line 23 * | 6,7,17 | TECHNICAL FIELDS SEARCHED (Int. Cl.4)  H 01 L |
| A | JOURNAL OF THE ELECTOCHEMICAL SOCIETY, vol. 130, no. 7, July 1983, pages 1543-1548, Manchester, New Hampshire, US; L.K. WHITE: "Planarization properties of resist and polyimide coatings" * Page 1543, right-hand column - page 1545; page 1547 * | 1,9 | |

The present search report has been drawn up for all claims

| Place of search | Date of completion of the search | Examiner |
|---|---|---|
| THE HAGUE | 28-06-1988 | GELEBART J.F.M. |